# EUROPÄISCHE PATENTSCHRIFT

(11) **EP 2 915 181 B1**
(45) Veröffentlichungstag und Bekanntmachung des Hinweises auf die Patenterteilung: **25.03.2020**
(21) Anmeldenummer: 13792254.8
(22) Anmeldetag: 29.10.2013
(51) Int. Cl.: H01J 37/34, C23C 14/34

(54) **LEISTUNGSVERTEILER ZUR DEFINIERTEN SEQUENZIELLEN LEISTUNGSVERTEILUNG**
POWER DISTRIBUTOR FOR DEFINED SEQUENTIAL POWER DISTRIBUTION
DISTRIBUTEUR DE PUISSANCE POUR DISTRIBUTION DE PUISSANCE SÉQUENTIELLE DÉFINIE

(30) Priorität: 01.11.2012 DE 102012021346
(43) Veröffentlichungstag der Anmeldung: 09.09.2015
(73) Patentinhaber: Oerlikon Surface Solutions AG, Pfäffikon, 8808 Pfäffikon SZ (CH)
(72) Erfinder: LENDI, Daniel, CH-9472 Grabs (CH)
(74) Vertreter: Troesch Scheidegger Werner AG
(86) Internationale Anmeldenummer: PCT/EP2013/003251
(87) Internationale Veröffentlichungsnummer: WO 2014/067650

(56) Entgegenhaltungen:
- EP-A1- 2 325 349
- DE-A1-102006 017 382
- DE-U1-202010 001 497
- JP-A- 2003 129 234
- JP-B2- 3 660 018

## Beschreibung

Die vorliegende Erfindung bezieht sich auf einen Schalter, welcher es erlaubt, die von einem Gleichstromgenerator zur Verfügung gestellte DC Leistung sequenziell auf mehr als zwei Lasten zu verteilen, ohne dass die Leistungsabgabe des Generators unterbrochen werden muss.

Leistungsgeneratoren kommen in unterschiedlichsten Anwendungen zum Einsatz. Ein Anwendungsbereich von Leistungsgeneratoren ist das sogenannte Magnetron Sputtern. Dabei handelt es sich um ein PVD Beschichtungsverfahren bei dem mit Hilfe eines Magnetrons durch lonenbeschuss Material von einem Target zerstäubt wird. Das zerstäubte Material kann sich dann auf einem zu beschichtenden Substrat niederschlagen. Ein Nachteil dieser konventionellen Sputtertechnologie ist der geringe Ionisierungsgrad des zerstäubten Materials. Je höher nämlich der Ionisierungsgrad umso effektiver kann ein Substratbias eingesetzt werden um das zerstäubte Material zum Substrat hin zusätzlich zu beschleunigen. Erst bei sehr hohen Stromdichten kommt es beim Sputtern zu einer überwiegenden Ionisation des zerstäubten Materials. Notwendige Bedingung für eine hohe Stromdichte ist jedoch ein hoher Leistungseintrag, welcher allerdings zu einer starken thermischen Belastung des Targets führt. Aus dem Grund wird im sogenannten HIPIMS-Verfahren die Leistung pulsweise auf das Target aufgebracht. Bei diesen hohen Leistungen ist es jedoch technisch schwierig entsprechende Pulsgeneratoren zu realisieren.

Gemäss einem neuen Verfahren wird die am Target benötigte Leistung nicht mehr durch einen Pulsgenerator zur Verfügung gestellt, sondern durch einen Gleichstromgenerator mit im Wesentlichen konstanter Leistungsabgabe. Gemäss diesem Verfahren werden mehr als zwei Targets nacheinander mit der Leistung des Gleichstromgenerators beaufschlagt. Prinzipiell lässt sich dies durch einfaches Umschalten von einem Target auf das nächste erreichen. Es hat sich allerdings in der Praxis gezeigt, dass dieses einfache Umschalten für die Targets sehr belastend ist, so dass es bereits nach nicht allzu häufigen Betriebsstunden zu Targetausfällen kommt. Es wird vermutet, dass dies u.a. auf die durch das Umschalten verursachten Leistungsspitzen zurückzuführen ist.

EP 2 235 349 A1 offenbart eine sequentielle Überlagerung von Pulsleistungen auf eine Grundleistung zum Betreiben mehrerer Targets in einer Sequenz.

Es wäre daher wünschenswert eine Schaltmöglichkeit zu haben, welche es erlaubt, die hohe Leistungsabgabe des Gleichstromgenerators zuverlässig und ohne übermässige Belastung der Targets sequenziell auf unterschiedliche Targets so zu verteilen, dass die vom Gleichstromgenerator abgegebene Leistung im Wesentlichen konstant ist.

Dies entspricht der Aufgabe der vorliegenden Erfindung.

Erfindungsgemäss wird die Aufgabe durch einen Leistungsverteiler gemäss Anspruch 1 gelöst. Es hat sich gezeigt, dass sich mit dem dementsprechenden Leistungsverteiler die Leistung zuverlässig und vor allen schonend sequenziell auf die unterschiedlichen Targets verteilen lässt.

Die Erfindung wird nun anhand eines Beispiels und mit Hilfe der Figuren im Detail erläutert.

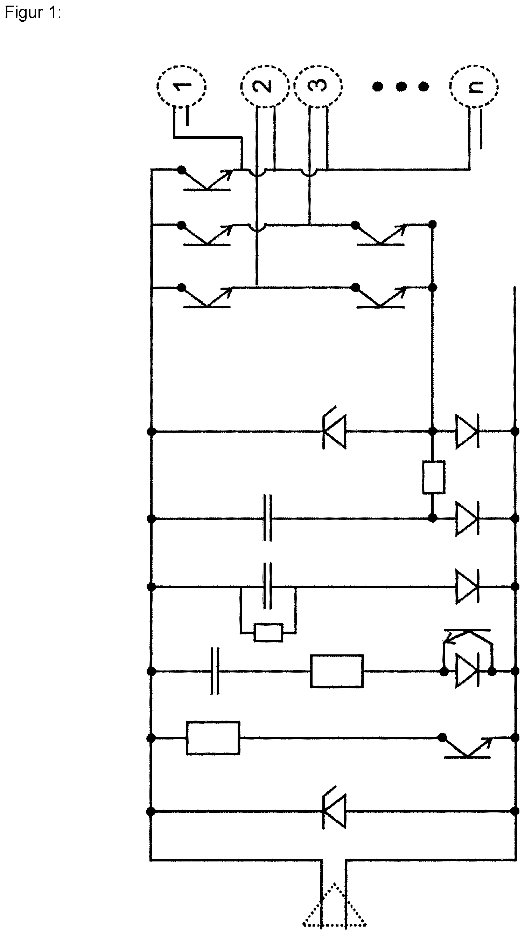

Figur 1 zeigt das allgemeine Schaltschema eines Leistungsverteilers gemäss einer Ausführungsform der vorliegenden Erfindung;
Figur 2 zeigt das Schaltschema eines erfindungsgemässen Leistungsverteilers, welcher die Leistung auf 6 Targets zu verteilen vermag;
Figur 3 zeigt das Schaltschema eines Leistungsverteilers gemäss einer Ausführungsform, die nicht Teil der Erfindung ist;
Figur 4 zeigt das Schaltschema eines erfindungsgemässen Leistungsverteilers gemäss einer weiteren Ausführungsform.

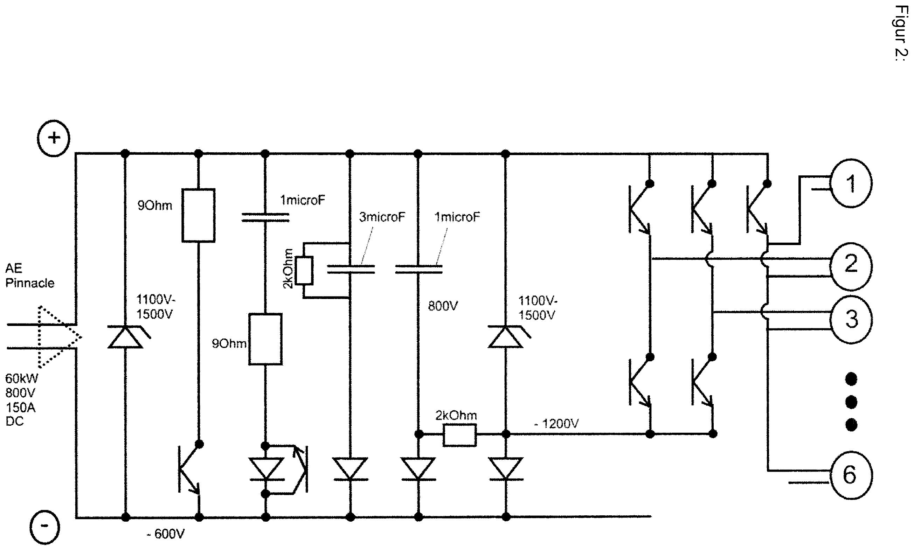

Im Beispiel der Figur 2 wird als DC Generator ein AE Pinnacle® eingesetzt, welcher eine DC Leistung von 60kW abzugeben vermag. Maximal können 800V eingestellt werden. Es können höchstens 150A fliessen. An den Ausgängen des DC Generators wird der Leistungsverteiler gemäss Figur 2 angeschlossen. An dessen Ausgänge werden jeweils separiert die 6 Targets angeschlossen. Die in der Figur 2 gezeigten Symbole sind dem Fachmann bekannt und es bedarf dementsprechend keiner weiteren Erläuterung. Dieser Leistungsverteiler gestattet es nun in einfacher Weise zunächst die volle Leistung des DC Generators auf das erste Target einzuspeisen und nach einem vorgegebenen ersten Zeitintervall auf das zweite Target umzuschalten und nach einem vorgegebenen zweiten Zeitintervall auf das dritte Target umzuschalten usw. bis schliesslich die Leistung auf das sechste Target eingespeist wird. Besonders bevorzugt ist die Tatsache, dass es mit Hilfe des erfindungsgemässen Leistungsverteilers möglich ist nach Beaufschlagung des sechsten Targets wieder mit der Beaufschlagung des ersten Targets zu beginnen und einen erneuten Schaltzyklus zu starten. Der entsprechende Vorgang lässt sich mehrmals wiederholen.

Die meisten DC Generatoren liefern nicht sofort nach dem Anschalten die volle Leistung. Es kommt daher zu einem Leistungsaufbauintervall. Mit dem erfindungsgemässen Leistungsverteiler lässt sich die Leistung während des Leistungsaufbauintervalls auf eine Leistungssenke leiten. Eine solche Leistungssenke kann beispielsweise ein einfacher ohmscher Widerstand sein. Nach einem Schaltzyklus, d.h. nach der Beaufschlagung des letzten Targets, muss die Leistung nicht mehr zunächst auf die Leistungssenke geleitet werden sondern es kann direkt wieder das erste Target mit Leistung beaufschlagt werden.

Der erfindungsgemässe Leistungsverteiler kann auch dazu genutzt werden, im Falle des sogenannten Arcings die Leistung auf die Leistungssenke umzuleiten bis das Arcing unterbunden ist. Auch in diesem Fall wird die Leistungsabgabe des DC Generators nicht unterbrochen und es muss zu keinem erneuten Leistungsaufbauintervall mehr kommen.

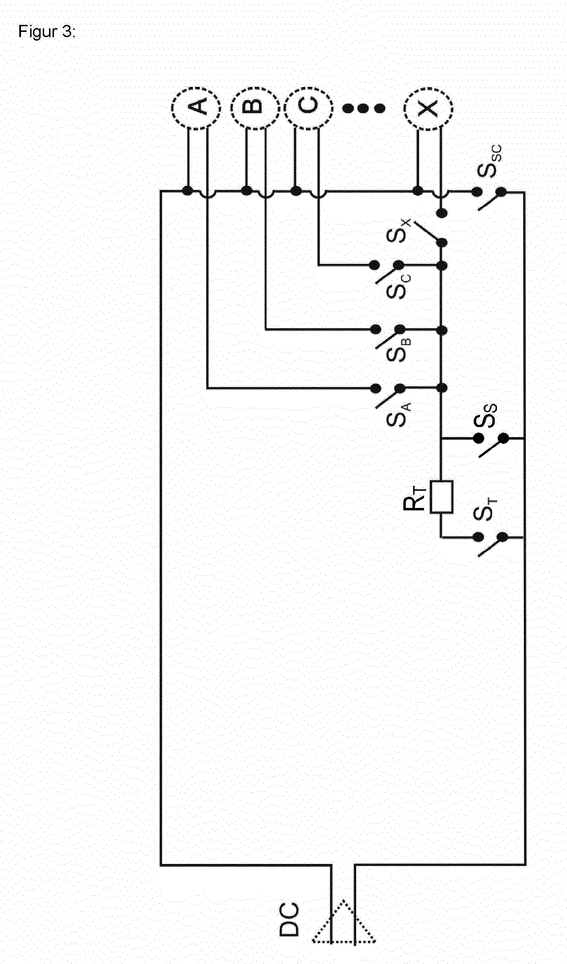

Figur 3 zeigt das Schema einer Ausführungsform. Dabei ist der Gleichstromgenerator DC als Dreieck mit einer Punktlinie gezeigt. Dessen positiver Ausgang liegt im Beispiel in direktem Kontakt mit allen Targets A bis X mit jeweils einem Anschluss. Der negative Ausgang des Gleichstromgenerators ist über einen Schalter S_{T}, hinter dem ein ohmscher Widerstand R_{T} angeordnet ist, ebenfalls mit allen Targets elektrisch verbunden. Allerdings kann die Verbindung zu Target A mittels des Schalters S_{A} unterbrochen werden. Die Verbindung zu Target B kann mittels Schalter S_{B} unterbrochen werden. Entsprechende Schalter Sc bis Sx sind für die weiteren Targets vorgesehen.

In der Anwendung wird nun Schalter S_{T} geschlossen. Anschliessend wird zusätzlich beispielsweise S_{A} geschlossen. Somit liegt die Spannung des Gleichstromgenerators DC am Target A. Es kommt zur Leistungsabgabe. Beispielsweise kann über dem Target A ein Plasma gezündet sein, so dass es am Target A zu einem Sputterprozess kommt. Aufgrund des Leistungseintrags auf das Target A kommt es sehr schnell zu einer Targeterwärmung. Bevor es dem Target A zu "heiss" wird, kann beispielsweise Target B mittels Schalter S_{B} angeschlossen werden. Wird gleichzeitig oder bevorzugt kurz darauf der Schalter S_{A} geöffnet, so "wandert" das Plasma von Target A zu Target B, und es kommt beim Target B zum vollen Leistungseintrag. Bevor sich das Target B zu sehr erhitzt, kann Target C über Schalter Sc zugeschaltet und Target B über Schalter S_{B} abgeschaltet werden. Analog kann mit den übrigen Targets bis zum letzten Target X verfahren werden. Bevor sich Target X zu sehr erhitzt, kann wieder Schalter S_{A} geschlossen werden und gleichzeitig oder bevorzugt kurz darauf Schalter Sx geöffnet werden. Somit wird ein neuer Schaltzyklus begonnen. Es können so viele Schaltzyklen aneinander gereiht werden wie gewünscht. Die Targets werden so periodisch für kurze Zeit mit Leistung beaufschlagt und haben, während die anderen Targets nacheinander mit Leistung beaufschlagt werden, eine längere Abkühlphase. Die Leistungsabgabe des Gleichstromgenerators DC ist währenddessen im Wesentlichen konstant. Sollte die Zeit der Abkühlphase nicht ausreichen, um ein Target auf eine gewünschte Temperatur abzukühlen, so kann nach einem oder mehreren Schaltzyklen die Leistungsabgabe beispielsweise mit Schalter S_{T} komplett unterbrochen werden.

In der Figur 3 eingezeichnet ist zusätzlich ein Schalter Ssc. Wird dieser geschlossen, so führt dies zu einem Kurzschluss der beiden Ausgänge des Gleichstromgenerators DC. Solche Gleichstromgeneratoren DC haben für den Kurzschlussfall in der Regel eine entsprechende Sicherung vorgesehen, die entsprechend aktiviert wird und zur Abschaltung führt. Schalter Ssc ist entsprechend für einen Störfall vorgesehen. Hierdurch wird eine Schnellabschaltung ermöglicht.

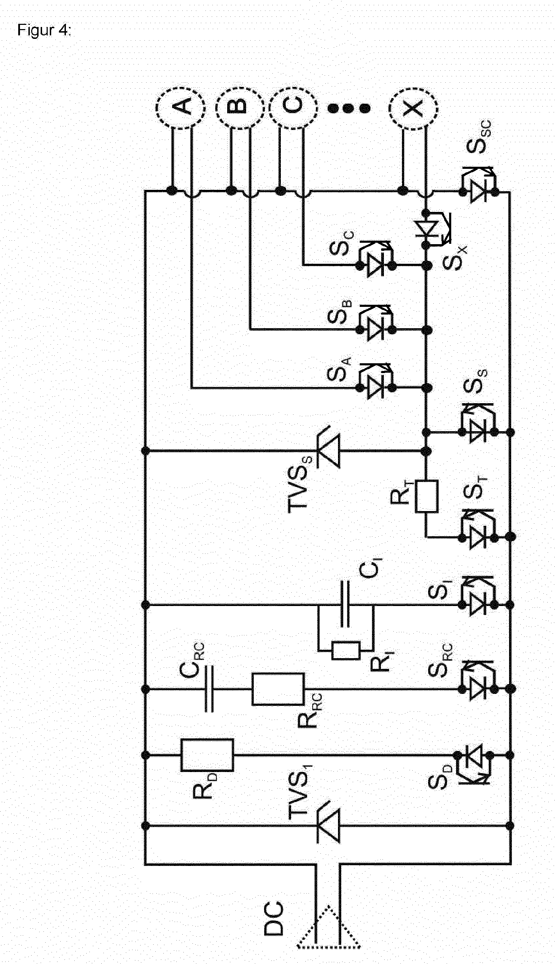

Bevorzugter Weise sind einige und besonders bevorzugt sämtliche Schalter als Bipolartransistor mit isolierter Gate-Elektrode (IGBT) ausgebildet. Dies ist in Figur 4 gezeigt.

Zusätzlich in Figur 4 dargestellt ist eine Schutzdiode TVS₁, welche direkt an die Ausgänge des Gleichstromgenerators DC angeschlossen ist. Hierdurch werden die anderen Bauteile vor zu hohen Spannungsspitzen geschützt.

Zusätzlich in Figur 4 dargestellt ist ein ohmscher Widerstand R_{D}, welcher über einen Schalter S_{D} an die Ausgänge des Gleichstromgenerators angeschlossen ist. Ist der Schalter als IGBT ausgeführt, so ist auf die Orientierung der Diode zu achten, die nicht der Orientierung der Dioden der anderen Schalter entspricht. Diese sogenannte Dummyload erfüllt die oben bereits beschriebenen zwei Funktionen der Leistungssenke. Dabei kann der Widerstand R_{D} ein aus unterschiedlichen z.B. parallel geschalteten ohmschen Widerständen aufgebauter Widerstand sein.

Zusätzlich in Figur 4 dargestellt ist die Schaltung eines RC Gliedes, wobei ein ohmscher Widerstand R_{RC}, ein Kondensator C_{RC} und ein Schalter S_{RC} in Reihe geschaltet sind. Dieses RC Glied ist an die Ausgänge des Gleichstromgenerators DC angeschlossen und ermöglicht es Leistungsschwankungen zu glätten. Auch hier können Widerstand R_{RC} und/oder Kondensator C_{RC} aus mehreren Einzelelementen aufgebaut sein.

Zusätzlich in Figur 4 dargestellt ist eine Zündunterstützung, welche einen Schalter S_{I}, einen Widerstand R_{I} und einen Kondensator C_{I} umfasst, wobei Widerstand R_{I} und Kondensator C_{I} zueinander parallel geschaltet sind. Dieser Teil des Schaltkreises ermöglicht die kurzzeitige Erzeugung sehr hoher Spannungen, so dass ein Plasma gezündet werden kann.

Zusätzlich in Figur 4 dargestellt ist eine weitere Schutzdiode TSVs, welcher auf der einen Seite direkt mit dem positiven Ausgang des Gleichstromgenerators DC verbunden ist und auf der anderen Seite die Verbindung zwischen Widerstand R_{T} und den Targetschaltern S_{A} bis Sx kontaktiert. Dieser Kontakt kann wiederum über einen Schalter Ss mit dem negativen Ausgang des Gleichstromgenerators verbunden sein, wie in der Figur 4 ebenfalls gezeigt.

Beispielwerte für die Widerstände und Kondensatoren:
- R_{D}:: 9 Ohm
- R_{RC}:: 9 Ohm
- R_{I}:: 2 kOhm
- R_{T}:: 2 kOhm
- C_{RC}:: 1 µF
- C_{I}:: 3 µF
- C:: 1 µF

## Patentansprüche

1. Leistungsverteiler, welcher dazu geeignet ist, die im Wesentlichen konstante Leistung eines Gleichstromgenerators (DC) sequenziell und ohne Unterbrechung der Leistungsabgabe auf mehr als zwei Targets (A,B,C,...,X) einer Beschichtungsanlage zu verteilen, wobei der Leistungsverteiler eine Schaltung umfasst, welche einen Ausgang des Gleichstromgenerators (DC) mit einem ersten Anschluss einer Kapazität (C) verbindet, und der andere Ausgang des Gleichstromgenerators (DC) mit einem zweiten Anschluss der Kapazität (C) verbunden ist und sich nach einem ohmschen Widerstand (R_{T}) an einem Verzweigungspunkt entsprechend der Anzahl der Targets verzweigt und jedes Target (A,B,C,...,X) mit einem der Zweige verbunden ist, wobei die Zweige jeweils einen dem Target (A,B,C,...,X) zugeordneten Schalter (S_{A}, S_{B}, Sc,...,Sx) aufweisen, durch die die Leitung zu dem zugeordneten Target (A,B,C,...,X) unterbrochen werden kann, **dadurch gekennzeichnet, dass** ein ohmscher Widerstand (R_{D}) vorgesehen ist, welcher bei angeschlossenem Gleichstromgenerator (DC) über einen Schalter (S_{D}) als Leistungssenke an die Ausgänge des Gleichstromgenerators (DC) angeschlossen ist, und dass im Leistungsverteiler die Schaltung eines RC Gliedes vorgesehen ist, welches bei angeschlossenem Gleichstromgenerator (DC) über einen Schalter (S_{RC}) an die Ausgänge des Gleichstromgenerators (DC) angeschlossen ist, um Leistungsschwankungen zu glätten.

2. Leistungsverteiler nach Anspruch 1, **dadurch gekennzeichnet, dass** im Leistungsverteiler eine Schaltung zur Zündunterstützung vorgesehen ist, welche einen Schalter (S_{I}), einen Widerstand (R_{I}) und einen Kondensator (C_{I}) umfasst, wobei der Widerstand (R_{I}) und der Kondensator (C_{I}) zueinander parallel geschaltet sind, und die Schaltung zur Zündunterstützung bei angeschlossenem Gleichstromgenerator (DC) an die Ausgänge des Gleichstromgenerators (DC) angeschlossen ist.

3. Leistungsverteiler nach Anspruch 2, **dadurch gekennzeichnet, dass** im Leistungsverteiler eine Schutzdiode (TVS₁) vorgesehen ist, welche bei angeschlossenem Gleichstromgenerator (DC) an die Ausgänge des Gleichstromgenerators (DC) angeschlossen ist.

4. Leistungsverteiler nach Anspruch 3, **dadurch gekennzeichnet, dass** zumindest einer der Schalter, vorzugsweise mehrere der Schalter und besonders bevorzugt alle Schalter als Bipolartransistor mit isolierter Gate-Elektrode ausgebildet sind.

5. Beschichtungsanlage, welche einen Gleichstromgenerator (DC) und mehrere als Sputterkathoden ausgebildete Targets (A,B,C,... ,X) umfasst, **dadurch gekennzeichnet dass** die Targets (A,B,C,... ,X) an den Gleichstromgenerator (DC) schaltbar über einen Leistungsverteiler nach einem der Ansprüche 1 bis 4 angeschlossen sind.

## Claims

1. Power distributor suited for distributing the substantially constant power of a direct current generator (DC) sequentially and without interruption of power delivery to more than two targets (A,B,C,...,X) of a coating apparatus, wherein the power distributor comprises a circuit, which connects an output of the direct current generator (DC) with a first connector of a capacitor (C), and the other output of the direct current generator (DC) is connected with a second connector of the capacitor (C) and branches at a branching point after an ohmic resistor (R_{T}) according to the number of targets and each target (A,B,C,...,X) is connected with one of the branches, wherein the branches feature a respective switch (S_{A}, S_{B}, S_{C},..., S_{X}) associated with the corresponding target (A,B,C,...,X), through which the conductor to the corresponding target (A,B,C,...,X) can be interrupted, **characterised in that** an ohmic resistor (R_{D}) is provided, which is connected via a switch (S_{D}) to the outputs of the direct current generator (DC) as a power sink whenever the direct current generator (DC) is connected, and **in that** the circuit of an RC element is provided in the power distributor, which element is connected via a switch (S_{RC}) to the outputs of the direct current generator (DC) whenever the direct current generator (DC) is connected for smoothing power variations.

2. Power distributor according to claim 1, **characterized in that** there is provided in the power distributor a circuit for supporting ignition, wherein the circuit comprises a switch (S_{I}), a resistance (R_{I}) and a capacitor (C_{I}), wherein the resistance (R_{I}) and the capacitor (C_{I}) are mutually connected in parallel and the circuit for supporting ignition is connected to the outputs of the direct current generator (DC) whenever the direct current generator (DC) is connected.

3. Power distributor according to claim 2, **characterized in that** there is provided in the power distributor a protective diode (TVS₁) which is connected to the outputs of the direct current (DC) generator whenever the direct current (DC) generator is connected.

4. Power distributor according to claim 3, **characterized in that** at least one of the switches, preferably more than one of the switches and especially preferred all switches are tailored as bi-polar transistor with isolated gate electrode.

5. Coating apparatus comprising a direct current generator (DC) and multiple targets (A,B,C,...,X) formed as sputtering cathodes **characterized in that** the targets (A,B,C,...,X) are switchably connectable to the direct current generator (DC) via a power distributor according to one of the claims 1 to 4.

## Revendications

1. Distributeur de puissance conçu pour distribuer la puissance essentiellement constante d'un générateur de courant continu (DC) de manière séquentielle et sans interruption de la puissance délivrée sur plus de deux cibles (A,B,C,...,X) d'une installation de revêtement, le distributeur de puissance comprenant un circuit qui relie une sortie du générateur de courant continu (DC) à un premier raccord d'un condensateur (C), et l'autre sortie du générateur de courant continu (DC) étant reliée à un deuxième raccord du condensateur (C) et se ramifiant après une résistance ohmique (R_{T}) à un point de ramification selon le nombre de cibles, et chaque cible (A,B,C,...,X) étant reliée à l'une des branches, les branches présentant chacune un commutateur (S_{A}, S_{B}, S_{C},..., S_{X}) associé à la cible (A,B,C,...,X), lesquelles permettent de couper la puissance à la cible (A,B,C,...,X) associée, **caractérisé en ce qu'**il est prévu une résistance ohmique (R_{D}), laquelle, lorsque le générateur de courant continu (DC) est raccordé, est raccordée aux sorties du générateur de courant continu (DC) par le biais d'un commutateur (S_{D}) comme puits de puissance, et **en ce qu'**il est prévu dans le distributeur de puissance le circuit d'un élément RC qui, lorsque le générateur de courant continu (DC) est raccordé, est raccordé aux sorties du générateur de courant continu (DC) par le biais d'un commutateur (S_{RC}) pour lisser les variations de puissance.

2. Distributeur de puissance selon la revendication 1, **caractérisé en ce qu'**il est prévu dans le distributeur de puissance un circuit pour aider à l'allumage, lequel comprend un commutateur (S_{I}), une résistance (R_{I}) et un condensateur (C_{I}), la résistance (R_{I}) et le condensateur (C_{I}) étant montés en parallèle et le circuit pour favoriser l'allumage étant raccordé, lorsque le générateur de courant continu (DC) est raccordé, aux sorties du générateur de courant continu (DC).

3. Distributeur de puissance selon la revendication 2, **caractérisé en ce qu'**il est prévu dans le distributeur de puissance une diode de protection (TVS₁) qui est raccordée, lorsque le générateur de courant continu (DC) est raccordé, aux sorties du générateur de courant continu (DC).

4. Distributeur de puissance selon la revendication 3, **caractérisé en ce qu'**au moins un des commutateurs, de préférence plusieurs commutateurs et de façon particulièrement préférée tous les commutateurs sont réalisés en tant que transistor bipolaire avec électrode de grille isolée.

5. Installation de revêtement comprenant un générateur de courant continu (DC) et plusieurs cibles (A,B,C,...,X) réalisées sous la forme de cathodes de pulvérisation, **caractérisée en ce que** les cibles (A,B,C,...,X) sont raccordées de façon commutable au générateur de courant continu (DC) par le biais d'un distributeur de puissance selon l'une des revendications 1 à 4.
